# EUROPÄISCHE PATENTSCHRIFT

(11) **EP 1 774 053 B1**
(45) Veröffentlichungstag und Bekanntmachung des Hinweises auf die Patenterteilung: **28.03.2012**
(21) Anmeldenummer: 05753711.0
(22) Anmeldetag: 21.06.2005
(51) Int. Cl.: C23C 14/06

(54) **VERFAHREN ZUR ERZEUGUNG EINER BESCHICHTUNG AUF EINEM KOLBENRING SOWIE KOLBENRING**
METHOD FOR PRODUCING A COAT ON A PISTON RING AND PISTON RING
PROCEDE POUR PRODUIRE UN REVETEMENT SUR UN SEGMENT DE PISTON, ET SEGMENT DE PISTON CORRESPONDANT

(30) Priorität: 03.07.2004 DE 102004032403
(43) Veröffentlichungstag der Anmeldung: 18.04.2007
(73) Patentinhaber: Federal-Mogul Burscheid GmbH, 51399 Burscheid (DE)
(72) Erfinder: FISCHER, Manfred, 42799 Leichlingen (DE); HOPPE, Steffen, 51491 Overath (DE)
(86) Internationale Anmeldenummer: PCT/DE2005/001103
(87) Internationale Veröffentlichungsnummer: WO 2006/005288

(56) Entgegenhaltungen:
- DE-A1- 4 112 422
- PATENT ABSTRACTS OF JAPAN Bd. 1996, Nr. 05, 31. Mai 1996 (1996-05-31) -& JP 08 021302 A (RIKEN CORP), 23. Januar 1996 (1996-01-23)
- PATENT ABSTRACTS OF JAPAN Bd. 1995, Nr. 10, 30. November 1995 (1995-11-30) -& JP 07 167300 A (RIKEN CORP), 4. Juli 1995 (1995-07-04)
- PATENT ABSTRACTS OF JAPAN Bd. 015, Nr. 206 (C-0835), 27. Mai 1991 (1991-05-27) -& JP 03 056658 A (HITACHI KOKI CO LTD), 12. März 1991 (1991-03-12)
- PATENT ABSTRACTS OF JAPAN Bd. 012, Nr. 091 (M-679), 24. März 1988 (1988-03-24) & JP 62 228648 A (RIKEN CORP), 7. Oktober 1987 (1987-10-07)

## Beschreibung

Die Erfindung betrifft ein Verfahren zur Erzeugung einer Beschichtung auf der äußeren Umfangsfläche eines Kolbenring-Grundkörpers.

Durch die DE-C 41 12 422 ist ein abriebfester Überzug der Chrom und mindestens ein Chromnitrid enthält bekannt geworden, der auf einem Trägermaterial gebildet ist. Die Stickstoffkonzentration des Überzuges nimmt von der Grenzfläche zwischen dem Trägermaterial und dem Überzug in Richtung auf die äußere Oberfläche des Überzuges kontinuierlich zu. Der Überzug hat einen der äußeren Oberfläche benachbarten Bereich, der im wesentlichen eine Mischung aus Cr₂N und CrN enthält. Der Überzug kann alternativ Chrom enthalten. Der abriebfeste Überzug kann beispielsweise auf gleitender Reibung unterliegenden Bauteilen, wie einem Kolbenring oder dergleichen, aufgebracht werden.

In der US-A 5,851,659 wird ein Gleitkörper und ein Verfahren zur Erzeugung eines derartigen Gleitkörpers abgehandelt, wobei der Gleitkörper mit einer Schicht auf Basis von Cr₂N versehen ist, die eine Porosität zwischen 1,5 und 20 % aufweist. Die Kristalle der Chromnitride sind hierbei parallel zur Oberfläche der Beschichtung ausgerichtet, wobei die Chromnitride der Beschichtung CrN, Cr₂N oder eine Mischung aus beiden Phasen beinhalten können.

In dem DE-Gbm 296 90 666 wird ein Bauteil im Bereich von Verbrennungsräumen abgehandelt, mit einer in einem Vakuumprozess zumindest auf einer seiner Flächen abgeschiedenen Beschichtung, die aus einer metallfreien amorphen Kohlenstoffschicht besteht, deren Härteverlauf über die Schichtdicke graduiert ist. Die Beschichtung soll hierbei in einem CVD-Prozeß aufgebracht werden, wobei die Graduierung durch Prozeßparameter einstellbar ist.

Kolbenringe, insbesondere einsetzbar in der ersten Nut eines Kolbens, werden unter anderem mit Verschleißschutzschichten, wie sie dem vorab beschriebenen Stand der Technik zu entnehmen sind, versehen, um die geforderte Lebensdauer erfüllen zu können. Höhere Zylinderdrücke, Direkteinspritzung, Abgasrückführung und andere Konstruktionsmerkmale neuerer Motorenentwicklungen, jedoch auch die Minimierung des Ölverbrauchs, belasten die Kolbenringe dermaßen, dass mit den herkömmlichen Kolbenringbeschichtungen die geforderten Lebensdauererwartungen nicht mehr garantiert werden können.

Durch den Stand der Technik sind Kolbenringbeschichtungen auf Basis von Chromnitrid nach der Dünnschichttechnologie teilweise mit Zusätzen an Sauerstoff und/oder Kohlenstoff bekannt geworden. Solche Schichten verfügen über gute Festigkeits- und Brandspureigenschaften. Um bei den vorliegenden Verschleißwerten die Forderungen an die Lebensdauer, insbesondere hoch beanspruchter Dieselmotoren, zu erreichen, müssen große Schichtdicken, die für die Dünnschichttechnologie untypisch sind, erzeugt werden. Diese werden durch mit der Schichtdicke ansteigende Einspannungen in der Schicht begrenzt, wodurch es zur Rissbildung in der Beschichtung und/oder zu Abplatzen kommen kann. Insbesondere bei der in der DE-C 41 12 422 dargelegten Beschichtung kann eine Kontiulität des Verschleißverhaltens über die Zeit gesehen nicht sichergestellt werden.
Aus der JP 08021302 A oder der JP 07167300 A sind PVD Schichten mit gradierten Schichten gekannt. Der Stickstoffanteil in der Beschichtung wird schrittweise verändert sodass sich die Zusammensetzung der Schicht ändert. Maßnahmen die darauf abzielen bei besonders dicken Schichten ein Abplatzen der Schichten zu vermeiden sind nicht offenbart.

Der Erfindung liegt die Aufgabe zugrunde, ein Verfahren zur Erzeugung einer Beschichtung auf der äußeren Umfangsfläche eines Kolbenring-Grundkörpers bereit zu stellen, durch welches Kolbenringbeschichtungen erzeugt werden können, die trotz der angegebenen Motorbelastungen ihre Funktion während der gesamten Lebensdauer des Motors zufriedenstellend erfüllen. Unter Einsatz der Dünnschichttechnologie soll darüber hinaus eine Schicht erzeugt werden, die die angesprochenen Nachteile nicht aufweist und die Abscheidung von Schichtdicken ermöglicht, die für hoch beanspruchte Motoren ein ausreichendes Funktionsverhalten, über die gesamte Lebensdauer des Motors gesehen, sicherstellt.

Diese Aufgabe wird erfindungsgemäß durch die Anprüche 1 und 6 gelöst.

Vorteilhafte Weiterbildungen des Erfindungsgegenstandes sind den verfahrensgemäßen Unteransprüchen zu entnehmen.

Vorteilhafte Weiterbildungen des erfindungsgemäßen Kolbenringes sind den zugehörigen gegenständlichen Unteransprüchen zu entnehmen.

Vorgeschlagen wird somit eine im PVD-Verfahren aufgebrachte Schicht auf Basis von CrN mit partiell gradiertem Schichtaufbau. Aus der Vielzahl von im PVD-Verfahren abscheidbaren Hartstoff-Schichtsystemen zeichnet sich das System Cr-N durch relativ geringe Eigenspannungen aus. Während andere Schichten nur mit wenigen µm Schichtdicke erzeugt werden können, bevor die entstehenden Eigenspannungen zu Schichtschäden führen, lassen sich CrN-Schichten in deutlich größeren Schichtdicken auftragen. Bei den für die Lebensdauer, insbesondere von Dieselmotoren, derzeit notwendigen Schichtdicken von 30 bis 50 µm, können bei herkömmlichen Beschichtungen die entstehenden Eigenspannungen aber doch zu Schichtabplatzern oder zur Rissbildung im Kolbenring-Grundwerkstoff führen.

Erfindungsgemäß werden die Eigenspannungen im System Cr-N bei höheren Schichtdicken dadurch reduziert, dass der Stickstoffgehalt innerhalb der Gradientenschicht in einer Rampenfunktion erhöht wird. Die erfindungsgemäße Schicht baut sich ausgehend vom Grundwerkstoff des Kolbenringes wie folgt auf
Grundwerkstoff - Cr-Haftschicht - CrN-Gradientenschicht - CrN-Deckschicht
Im Schichtsystem Cr-N existieren neben dem metallischen Cr mit Cr₂N (33 Atom-% N) und CrN (50 Atom-% N) zwei Nitride. Je nach eingestelltem Stickstoffpartialdruck im PVD-Prozess bilden sich die unterschiedlichen Phasen oder deren Phasengemische.

Im Beschichtungsprozess wird zunächst ohne Stickstoffzugabe zum Prozessgas eine metallische Cr-Schicht mit einer Schichtdicke < 1 µm abgeschieden. Anschließend wird dem Prozessgas Stickstoff zugegeben, wobei der Stickstoffpartialdruck kontinuierlich erhöht wird. Die Schichtzusammensetzung innerhalb der Gradientenschicht wird dabei von Cr über Cr - Cr₂N-Gemischen, Cr₂N, Cr₂N - CrN-Gemischen bis hin zum CrN variiert. Im Anschluss wird eine Deckschicht konstanter Zusammensetzung abgeschieden. Es kann sich dabei um CrN, Cr₂N oder einem Gemisch aus beiden Phasen handeln.

Überraschender Weise hat sich gezeigt, dass bei Gesamtschichtdicken zwischen 30 und 50 µm eine Gradientenschichtdicke von 3 bis 5 µm ausreicht, die Eigenspannungen soweit zu reduzieren, dass keine Schichtabplatzer oder Rissbildungen mehr auftreten.

Der Erfindungsgegenstand ist anhand eines Ausführungsbeispieles in der Zeichnung dargestellt und wird wie folgt beschrieben. Es zeigen
- Figur 1: Querschnitt durch einen Kolbenring-Grundkörper mit darauf aufgebrachter Laufflächenbeschichtung
- Figur 2: Konzentrationsprofil Cr-N, der in Figur 1 dargestellten Laufflächenbeschichtung.

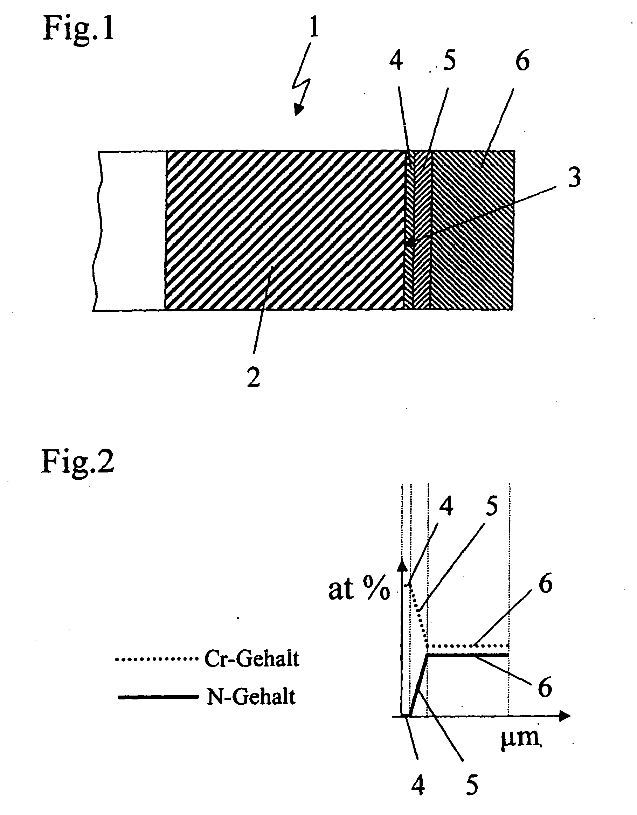

Figur 1 zeigt den Querschnitt eines Kolbenringes 1, beinhaltend einen Grundkörper 2, der mit einer eine Lauffläche bildenden äußeren Umfangsfläche 3 versehen ist. Auf der äußeren Umfangsfläche 3 sind in diesem Beispiel drei Schichten 4,5,6 nach dem PVD-Verfahren aufgebracht worden. In diesem Beispiel soll die Schicht 4 durch eine Haftschicht auf Basis von Cr gebildet sein und eine Schichtdicke von 0,5 µm aufweisen.

Auf die Haftschicht 4 wurde ebenfalls im PVD-Verfahren eine CrN-Gradientenschicht 5 mit einer Schichtdicke von 3 µm aufgebracht. Die Schichtzusammensetzung innerhalb der CrN-Gradientenschicht 5 wurde dergestalt durch Stickstoffzugabe zum Prozessgas variiert, dass Abscheidungen vom Cr über Cr - Cr₂N-Gemischen, Cr₂N, Cr₂ - CrN-Gemischen bis hin zum CrN einstellbar waren.

Auf die CrN-Gradientenschicht 5 wurde ebenfalls im PVD-Verfahren eine Deckschicht 6 konstanter Zusammensetzung mit einer Schichtdicke von 30 µm aufgebracht, wobei es sich hierbei um CrN handelt. Cr₂N oder aber ein Gemisch aus beiden Phasen ist ebenfalls denkbar.

In einem Versuch wurde eine CrN-Schicht von 30 µm Gesamtschichtdicke auf einem Kolbenring 1 abgeschieden. In einem Fall wurde zunächst eine Cr-Haftschicht von 0,5 µm aufgebracht, im anderen Fall ebenfalls eine Cr-Haftschicht gleicher Dicke und zusätzlich eine 3 µm dicke Gradientenschicht aufgetragen. Die Variante mit Gradientenschicht wies nur halb so hohe Druckeigenspannungen auf, wie die Schicht ohne Gradientenschicht.

Figur 2 zeigt das Konzentrationsprofil der in Figur 1 beschriebenen Beschichtung. Erkennbar sind die Cr- und N-Gehalte in Atom-% sowie die Schichtdicken in µm. Im Beschichtungsprozess wird zunächst ohne Stickstoffzugabe zum Prozessgas eine metallische Cr-Schicht (Haftschicht 4) abgeschieden. Erfindungsgemäß werden die Eigenspannungen im System Cr-N bei höheren Schichtdicken dadurch reduziert, dass der Stickstoffgehalt der CrN-Gradientenschicht 5 in einer Rampenfunktion erhöht wird, dergestalt, dass Stickstoff dem Prozessgas zugegeben wird, wobei der Stickstoffpartialdruck in diesem Beispiel kontinuierlich erhöht wird. Die Schichtzusammensetzung in der CrN-Gradientenschicht 5 wird dabei von Cr über Cr - Cr₂N-Gemischen, Cr₂N, Cr₂N - CrN-Gemischen bis hin zum CrN variiert. Im Anschluss wird eine Deckschicht 6 konstanter Zusammensetzung abgeschieden, wobei es sich hier um CrN handelt.

## Patentansprüche

1. Verfahren zur Erzeugung einer Beschichtung auf der äußeren eine Lauffläche bildende Umfangsfläche (3) eines Kolbenring-Grundkörpers (2), indem mehrere Schichten (4,5,6) lagenweise dergestalt auf der Umfangsfläche (3) aufgebracht werden, dass im PVD-Verfahren zunächst mindestens eine metallische Haftschicht (4) auf Basis von Cr ohne Zugabe von Stickstoff zum Prozessgas auf der Umfangsfläche (3) aufgebracht wird, anschließend dem Prozessgas Stickstoff unter Erhöhung des Stickstoffpartialdruckes zur Bildung einer CrN-Gradientenschicht auf der Haftschicht (4) zugegeben wird, und abschließend mindestens eine Deckschicht (6) konstanter Zusammensetzung auf Basis von CrN, Cr₂N oder einem Gemisch aus beiden Phasen auf der CrN-Gradientenschicht (5) aufgebracht wird **dadurch gekennzeichnet, dass** die Erhöhung des Stickstoffpartialdruckes kontinuierlich erfolgt solange bis die CrN-Gradientenschicht (5) mit einer Schichtdicke zwischen 1 und 8 µm erzeugt wird und danach die Deckschicht mit einer Schichtdicke zwischen 10 und 80 µm erzeugt wird.

2. Verfahren nach Anspruch 1, **dadurch gekennzeichnet, dass** die Erhöhung des Stickstoffpartialdruckes nach Art einer Rampenfunktion vorgenommen wird.

3. Verfahren nach einem der Ansprüche 1 und 2, **dadurch gekennzeichnet, dass** die Schichtzusammensetzung innerhalb der CrN-Gradientenschicht (5) von Cr über Cr - Cr₂N-Gemischen, Cr₂N, Cr₂N - CrN-Gemischen bis hin zum CrN variiert wird.

4. Verfahren nach einem der Ansprüche 1 bis 3, **dadurch gekennzeichnet, dass** die Haftschicht (4) mit einer Schichtdicke zwischen 0,1 und 1 µm erzeugt wird.

5. Verfahren nach einem der Ansprüche 1 bis 5, **dadurch gekennzeichnet, dass** bei einer Gesamtschichtdicke zwischen 30 und 50 µm eine CrN-Gradientenschicht (5) mit einer Schichtdicke zwischen 2 und 6 µm und eine Haftschicht (4) mit einer Schichtdicke < 0,6 µm erzeugt wird.

6. Kolbenring, bestehend aus einem Grundkörper (2) auf dessen äußerer eine Lauffläche bildende Umfangsfläche (3) mehrere Schichten (4, 5, 6) lagenweise übereinander aufgebracht sind, wobei die der äußeren Umfangsfläche (3) zugewandte Haftschicht (4) eine PVD-Haftschicht auf Basis von Cr ist, auf der Haftschicht (4) eine CrN-Gradientenschicht (5) mit einer Schichtzusammensetzung von Cr über Cr - Cr₂N-Gemischen, Cr₂N, Cr₂N - CrN-Gemischen bis hin zum CrN aufgebracht und auf der CrN-Gradientenschicht (5) mindestens eine Deckschicht (6) konstanter Zusammensetzung auf Basis von CrN, Cr₂N oder einem Gemisch aus beiden Phasen aufgebracht ist **dadurch gekennzeichnet, dass** die CrN-Gradientenschicht (5) eine Schichtdicke zwischen 1 und 8 µm und die Deckschicht (6) eine Schichtdicke zwischen 10 und 80 µm aufweist.

7. Kolbenring nach Anspruch 6, **dadurch gekennzeichnet, dass** die Haftschicht (4) eine Schichtdicke zwischen 0,1 und 1 µm aufweist.

8. Kolbenring nach einem der Ansprüche 6 oder 7, **dadurch gekennzeichnet, dass** bei einer Gesamtschichtdicke von 30 bis 50 µm die Haftschicht (4) eine Schichtdicke < 0,6 µm und die CrN-Gradientenschicht (5) eine Schichtdicke zwischen 2 und 6 µ aufweist.

## Claims

1. A method for producing a coat on the outer circumferential surface (3), which forms a bearing surface, of a base body (2) of a piston ring, in that several layers (4, 5, 6) are applied in plies on the circumferential surface (3) in such a way that at first at least one metallic adhesive layer (4) on the base of Cr is applied on the circumferential surface (3) by the PVD method without addition of nitrogen to the process gas, afterwards nitrogen is added to the process gas while increasing the nitrogen partial pressure for forming a CrN gradient layer on the adhesive layer (4), and finally at least one cover layer (6) having a constant composition on the base of CrN, Cr₂N or a mixture of both phases is applied on the CrN gradient layer (5), **characterized in that** the increase of the nitrogen partial pressure is realized continuously until the CrN gradient layer (5) having a layer thickness comprised between 1 and 8 µm is produced and afterwards the cover layer having a layer thickness comprised between 10 and 80 µm is produced.

2. A method according to claim 1, **characterized in that** the nitrogen partial pressure is increased in the way of a ramp function.

3. A method according to one of the claims 1 and 2, **characterized in that** the layer composition within the CrN gradient layer is varied from Cr, Cr - Cr₂N mixtures, Cr₂N, Cr₂N - CrN mixtures up to CrN.

4. A method according to one of the claims 1 through 3, **characterized in that** the adhesive layer (4) is produced to have a layer thickness comprised between 0.1 and 1 µm.

5. A method according to one of the claims 1 through 4, **characterized in that** if the total layer thickness is comprised between 30 and 50 µm, a CrN gradient layer (5) having a layer thickness comprised between 2 and 6 µm and an adhesive layer (4) having a layer thickness of < 0.6 µm will be produced.

6. A piston ring composed of a base body (2), on the external circumferential surface (3) of which, which forms a bearing surface, several layers (4, 5, 6) are applied in plies one on top of the other, wherein the adhesive layer (4) facing the external circumferential surface (3) is a PVD adhesive layer on the base of Cr, wherein a CrN gradient layer (5) having a layer composition of Cr, Cr - Cr₂N mixtures, Cr₂N, Cr₂N - CrN mixtures or CrN is applied on the adhesive layer (4) and at least one cover layer (6) having a constant composition on the base of CrN, Cr₂N or a mixture of both phases is applied on the CrN gradient layer (5), **characterized in that** the CrN gradient layer (5) comprises a layer thickness comprised between 1 and 8 µm and the cover layer (6) comprises a layer thickness comprised between 10 and 80 µm.

7. A piston ring according to claim 6, **characterized in that** the adhesive layer (4) comprises a layer thickness comprised between 0.1 and 1 µm.

8. A piston ring according to one of the claims 6 or 7, **characterized in that** if the total layer thickness is comprised between 30 and 50 µm, the adhesive layer (4) comprises a layer thickness of < 0.6 µm and the CrN gradient layer (5) comprises a layer thickness comprised between 2 and 6 µm.

## Revendications

1. Procédé pour produire un revêtement sur la surface circonférentielle (3) extérieure formant une surface de roulement d'un corps de base (2) d'un segment de piston en ce qu'on applique plusieurs couches (4, 5, 6) par couches consécutives sur la surface circonférentielle (3) de façon à ce que tout d'abord on applique au moins une couche adhésive métallique (4) à base de Cr sur la surface circonférentielle (3) par moyen du procédé PVD sans addition d'azote au gaz de procédé, après on ajoute de l'azote au gaz de procédé en augmentant la pression partielle d'azote pour former une couche de gradient de CrN sur la couche adhésive (4), et finalement on applique au moins une couche de recouvrement (6) ayant une composition constante à base de CrN, Cr₂N ou d'un mélange des deux phases sur la couche de gradient de CrN (5), **caractérisé en ce que** l'augmentation de la pression partielle d'azote se fait continuellement jusqu'à ce que la couche de gradient de CrN (5) ayant une épaisseur de couche comprise entre 1 et 8 µm soit produite et après la couche de recouvrement ayant une épaisseur de couche comprise entre 10 et 80 µm est produite.

2. Procédé selon la revendication 1, **caractérisé en ce qu'**on réalise l'augmentation de la pression partielle d'azote à la manière d'une fonction de rampe.

3. Procédé selon l'une des revendications 1 et 2, **caractérisé en ce qu'**on varie la composition de couche à l'intérieur de la couche de gradient de CrN (5) entre Cr, des mélanges Cr - Cr₂N, Cr₂N, des mélanges Cr₂N - CrN et CrN.

4. Procédé selon l'une des revendications 1 à 3, **caractérisé en ce qu'**on produit la couche adhésive (4) avec une épaisseur de couche comprise entre 0,1 et 1 µm.

5. Procédé selon l'une des revendications 1 à 4, **caractérisé en ce que** si l'épaisseur totale de couche est comprise entre 30 et 50 µm, on produira une couche de gradient de CrN (5) ayant une épaisseur de couche comprise entre 2 et 6 µm et une couche adhésive (4) ayant une épaisseur de couche de < 0,6 µm.

6. Segment de piston composé d'un corps de base (2), dans lequel plusieurs couches sont appliquées par couches consécutives sur la surface circonférentielle extérieure (3) formant une surface de roulement de celui-ci, la couche adhésive (4) qui se trouve en face de la surface circonférentielle extérieure (3) étant une couche adhésive de PVD à base de Cr, une couche de gradient de CrN (5) ayant une composition de couche variée entre Cr, des mélanges Cr - Cr₂N, Cr₂N, des mélanges Cr₂N - CrN et CrN étant appliquée sur la couche adhésive (4) et au moins une couche de recouvrement (6) ayant une composition constante à base de CrN, Cr₂N ou d'un mélange des deux phases étant appliquée sur la couche de gradient de CrN (5), **caractérisé en ce que** la couche de gradient de CrN (5) comprend une épaisseur de couche comprise entre 1 et 8 µm et la couche de recouvrement (6) comprend une épaisseur de couche comprise entre 10 et 80 µm.

7. Segment de piston selon la revendication 6, **caractérisé en ce que** la couche adhésive (4) comprend une épaisseur de couche comprise entre 0,1 et 1 µm.

8. Segment de piston selon l'une des revendications 6 ou 7, **caractérisé en ce que** si l'épaisseur totale de couche est comprise entre 30 et 50 µm, la couche adhésive (4) comprendra une épaisseur de couche de < 0,6 µm et la couche de gradient de CrN (5) comprendra une épaisseur de couche comprise entre 2 et 6 µm.
